# EUROPEAN PATENT APPLICATION

(11) **EP 4 503 145 A1**
(43) Date of publication of application: **05.02.2025**
(21) Application number: 23775360.3
(22) Date of filing: 24.03.2023
(51) Int. Cl.: H01L 31/18, H01L 31/20

(54) **TABBING DEVICE FOR MANUFACTURING SOLAR CELL MODULE**

(30) Priority: 24.03.2022 KR 20220036662
(71) Applicant: Hanwha Solutions Corporation, Jung-gu Seoul 04541 (KR)
(72) Inventor: LEE, Min Su, Seoul 04541 (KR); LIM, Moon Taek, Seoul 04541 (KR); KIM, Sung Jin, Seoul 04541 (KR)
(74) Representative: HGF
(86) International application number: PCT/KR2023/003974
(87) International publication number: WO 2023/182865

(57) **Abstract**

A tabbing apparatus for manufacturing solar cell modules according to an embodiment of the present disclosure includes a conveyor for sequentially transporting solar cells including a soldering completed cell, a working target cell, and a soldering standby cell; a soldering head in which an infrared radiation device for directly radiating infrared rays to the cell is disposed such that a wiring material on a surface of the solar cell, which is disposed on the conveyor, is soldered; and an over-soldering prevention member disposed between the conveyor and the soldering head and including a light blocking portion and a light transmitting portion inside the light blocking portion, wherein the over-soldering prevention member includes an opening portion having a structure in which the light transmitting portion extends towards the light blocking portion.

## Description

### TECHNICAL FIELD

The present disclosure relates to a tabbing apparatus for manufacturing solar cell modules, and more particularly, to a tabbing apparatus for manufacturing solar cell modules that is capable of preventing over-soldering by heating solar cells which are on standby for soldering and/or solar cells for which the soldering has been completed in a manufacturing process for the solar cell modules.

### BACKGROUND ART

It is spurring to discover new energy sources around the world, and among such energy sources, solar power generation, which converts infinite and pollution-free solar energy into electrical energy, is attracting attention. For the solar power generation and the conversion, solar cells that coverts solar energy into electrical energy are required.

These solar cells are manufactured by bonding semiconductor materials into p-n junction using a diffusion method and use the photoelectric effect by which a small amount of current flows when receiving light, and most conventional solar cells are made up of large area p-n junction diodes and function as a unit solar cell when the electromotive force generated between both ends of the p-n junction diode is connected to an external circuit.

The size of the solar cell is on the rise from the existing 156mm x 156mm, and the output of solar cell is also increasing as the size of the solar cell increases. However, there is still a limit to the output of a single solar cell, and in order to obtain the desired output for power generation, a solar cell module is to be manufactured by connecting a certain number of solar cells or more in series.

A manufacturing process for the solar cell module may be roughly divided into the following processes: a cell test process, a tabbing-string process, a layup process, a lamination process, and a module test process. First, in the cell test process, cells with various electrical properties are tested and sorted into cells with similar electrical properties, and secondly, in the tabbing-string process, conductive wiring materials are bonded to front and rear surfaces of the solar cells in a staggered manner so as to connect the solar cells in series. Thirdly, in the layup process, a series of the solar cells formed in the string process are arranged horizontally again to form the desired shape, and then a low-iron tempered glass, ethylene vinyl acetate (EVA) films, and a backsheet are stacked thereon. Fourthly, in the lamination process, the stacked materials for the solar cell module are compressed under high temperature, to thereby allow the solar cell module to withstand impact and be waterproof at the same time. Lastly, in the module test process, it is verified whether the completed solar cell module can normally implement output.

At this time, the tabbing process is a process for connecting positive (+) and negative (-) polarities of several cells in series in such a way that the negative (-) electrode of one cell is connected to the positive (+) electrode of the next cell with the wiring material sequentially and continuously, so when the wiring material is cut in the middle or is not bonded properly, the solar cell module product is entirely defective, which makes the tabbing process important step for determining the quality of the module. In order to perform the tabbing process, a number of solar cells, which are capable of implementing the desired output, are arranged on an upper surface of the tabbing apparatus in the form of a square plate in accordance with rows and columns. At this time, welding solder is applied to the areas on which the welding solder is to be attached at top and bottom of each cell, and wiring material wires are placed on the electrodes applied with welding solder. In this state, the ribbon is fixed to each unit solar cell by soldering the contact area in various ways. In this process, the soldering may be performed directly by a person or automatically by a machine. Even when the soldering is performed automatically by a machine, it may be divided into a hot air method, a laser method, an induction method, a lamp method, and a resistance heating method depending on the method.

Among the soldering methods, the laser method, the induction method, and the resistance heating method have the advantage of locally transferring heat to minimize and integrate the range but have a problem of spending excessive costs on the process apparatus for implementing this method. On the other hand, the lamp method is a method of soldering using radiant heat emitted from a lamp and has the advantage of being able to heat a wide area at a low cost but has a problem of transferring more heat than necessary to the solar cell.

### DETAILED DESCRIPTION OF INVENTION

### TECHNICAL PROBLEM

One of the many purposes of the present disclosure is to provide a tabbing apparatus for manufacturing solar cell modules that may prevent over-soldering.

One of the many purposes of the present disclosure is to provide a tabbing apparatus for manufacturing solar cell modules capable of local heating.

One of the many purposes of the present disclosure is to provide a tabbing apparatus for manufacturing solar cell modules that allows easy control of the soldering area.

### TECHNICAL SOLUTION TO PROBLEM

A tabbing apparatus for manufacturing solar cell modules according to an embodiment of the present disclosure may include a conveyor for transporting sequentially solar cells including a soldering completed cell, a working target cell, and a soldering standby cell; a soldering head in which an infrared radiation device for directly radiating infrared rays to the cell is disposed such that a wiring material on a surface of the solar cell, which is disposed on the conveyor, is soldered; and an over-soldering prevention member disposed between the conveyor and the soldering head and including a light blocking portion and a light transmitting portion inside the light blocking portion, wherein the over-soldering prevention member includes an opening portion having a structure in which the light transmitting portion extends towards the light blocking portion.

At this time, a width of the infrared ray that is radiated from the infrared radiation device to the surface of the solar cell which is positioned on the conveyor is greater than a width of the wiring material attached to the solar cell.

In an embodiment of the present disclosure, a length of the infrared ray that is radiated from the infrared radiation device to the surface of the solar cell which is positioned on the conveyor is greater than a length of the wiring material attached to the solar cell.

In an embodiment, the light blocking portion of the over-soldering prevention member may be disposed to block the infrared rays emitted to the soldering completed cell that is positioned at a side in a moving direction of the conveyor compared to the solar cell that is below the infrared radiation device.

In an embodiment of the present disclosure, the light blocking portion of the over-soldering prevention member may be disposed to block the infrared rays emitted to the soldering standby cell that is positioned at a side opposite to the moving direction of the conveyor compared to the solar cell that is below the infrared radiation device.

According to an embodiment of the present disclosure, the light blocking portion of the over-soldering prevention member may be disposed to block the infrared rays emitted to areas other than the working target cell that is positioned below the infrared radiation device.

The opening portion in the tabbing apparatus for manufacturing solar cell modules according to an aspect of the present disclosure may be formed and disposed at a side opposite to the moving direction of the conveyor.

In an example of the present disclosure, the opening portion of the tabbing apparatus for manufacturing solar cell modules may be disposed on opposite sides of the light blocking portion in a width direction.

In an embodiment of the present disclosure, the over-soldering prevention member of the tabbing apparatus for manufacturing solar cell modules may further include an adjuster capable of adjusting a length of the light transmitting portion.

In an embodiment, the infrared radiation device in the tabbing apparatus for manufacturing solar cell modules according to the present disclosure may include an infrared lamp or a halogen lamp.

### ADVANTAGEOUS EFFECTS OF INVENTION

One of the many effects of the present disclosure is to prevent over-soldering in the manufacturing process for the solar cell module.

One of the many effects of the present disclosure is to provide a tabbing apparatus for manufacturing solar cell modules capable of heating a local area.

One of the many effects of the present disclosure is to provide a tabbing apparatus for manufacturing solar cell modules that allows easy control of the soldering area.

### BRIEF DESCRIPTION OF DRAWINGS

FIG. 1 is a perspective view schematically illustrating a tabbing apparatus for manufacturing solar cell modules according to an embodiment of the present disclosure.
FIG. 2 is a schematic view for explaining the operation of a tabbing apparatus for manufacturing solar cell modules according to an embodiment of the present disclosure.
FIG. 3 is a schematic view for explaining an operation of a tabbing apparatus for manufacturing solar cell modules according to another embodiment of the present disclosure.
FIG. 4 is a plan view schematically illustrating an over-soldering prevention member of a tabbing apparatus for manufacturing solar cell modules according to an embodiment of the present disclosure.
FIGS. 5 and 6 are plan views schematically illustrating a modified form of the over-soldering prevention member in FIG. 4.
FIG. 7 is a schematic view for explaining the operation of a conventional tabbing apparatus for manufacturing solar cell modules.

### BEST MODE OF INVENTION

A tabbing apparatus for manufacturing solar cell modules according to an embodiment of the present disclosure includes a conveyor for sequentially transporting solar cells including a soldering completed cell, a working target cell, and a soldering standby cell; a soldering head in which an infrared radiation device for directly radiating infrared rays to the cell is disposed such that a wiring material on a surface of the solar cell, which is disposed on the conveyor, is soldered; and an over-soldering prevention member disposed between the conveyor and the soldering head and including a light blocking portion and a light transmitting portion inside the light blocking portion, wherein the over-soldering prevention member includes an opening portion having a structure in which the light transmitting portion extends towards the light blocking portion.

### MODE OF INVENTION

Hereinafter, embodiments of the present disclosure will be described with reference to specific embodiments and attached drawings. This is not intended to limit the technology described herein to specific embodiments, but should be understood to include various modifications, equivalents, and/or alternatives of the embodiments of the present disclosure. With regard to the description of the drawings, similar reference numbers may be used for similar components.

In addition, in order to clearly explain the present disclosure in the drawings, parts that are not related to the description are omitted, and the thickness is enlarged to clearly express various layers and areas, and components with the same function within the scope of the same idea may be explained using the same reference numerals.

In this specification, terms such as "comprise" or "have" are intended to describe the existence of features, numbers, steps, operations, components, parts, or combinations thereof described in the specification, but it should be understood that the presence or additional possibilities of one or more other features, numbers, steps, operations, components, parts, or combinations thereof are not precluded.

The fact that a component is in the "front", "back", "top" or "bottom" of another component includes being disposed in the "front", "back", "top" or "bottom" in direct contact with the other component, unless otherwise specified, as well as another component being disposed in the middle. In addition, the fact that a component is "connected" to another component includes not only being directly connected to each other, but also indirectly connected to each other, unless otherwise specified.

In the present specification, expressions such as "A and/or B," "at least one of A and B," or "one or more of A and B" may include all possible combinations of the items listed together. For example, "A and/or B," "at least one of A and B," or "one or more of A and B" may refer to all cases of (1) including at least one A, (2) including at least one B, or (3) including both at least one A and at least one B.

In the drawings, an X direction may be defined as a first direction, an L direction or a length direction, a Y direction may be defined as a second direction, a W direction or a width direction, and a Z direction may be defined as a third direction, a T direction, or a thickness direction. In addition, a transport direction of the conveyor described below in this specification may be defined as the X direction, a direction that is perpendicular to the X direction and directed to an infrared radiation device from a working target cell which is described below may be defined as the Z direction, and a direction perpendicular to both the X direction and the Z direction may be defined as the Y direction.

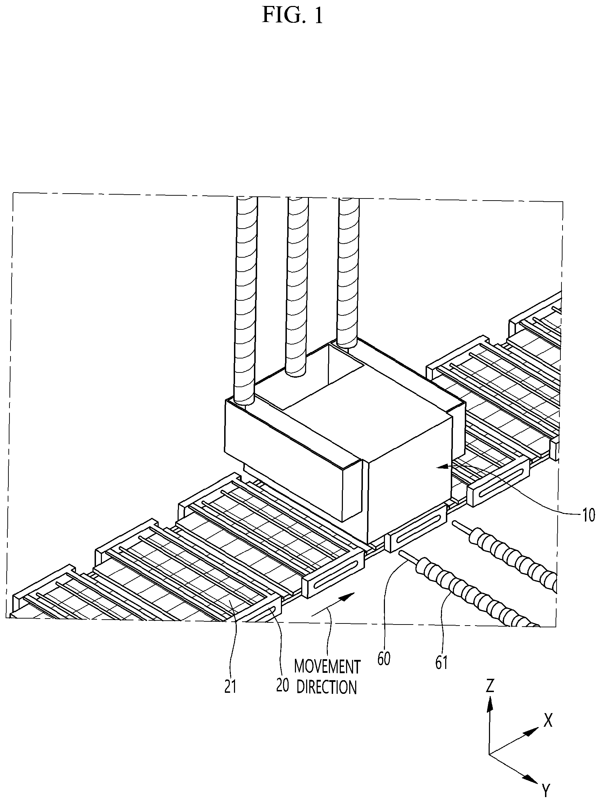

The present disclosure relates to a tabbing apparatus for manufacturing solar cell modules. Hereinafter, the present disclosure is described with reference to FIGS. 1 to 6.

Referring to FIGS. 1 to 6, a tabbing apparatus for manufacturing solar cell modules according to an embodiment of the present disclosure may include a conveyor 20 for transferring solar cells 21 including a soldering completed cell, a working target cell, and a soldering standby cell; a soldering head 10 in which an infrared radiation device 11 is disposed and directly radiates infrared rays to the cell to solder wiring material on a surface of the solar cell 21 disposed on the conveyor 20; and an over-soldering prevention member 30 disposed between the conveyor 20 and the soldering head 10 and having a light blocking portion 31 and a light transmitting portion 32 inside the light blocking portion 31.

At this time, the over-soldering prevention member 30 may include an opening portion 33 having a structure in which the light transmitting portion 32 extends towards the light blocking portion 31. In this specification, the ^{┌}light blocking portion_{┘} may refer to an area where the infrared rays emitted from the infrared radiation device are blocked, and the ^{┌}light transmitting portion_{┘} may refer to an area where the infrared rays emitted from the infrared radiation device pass through the over-soldering prevention member to reach the working target cell which is disposed on the conveyor described above.

In addition, in this specification, ^{┌}working target cell_{┘} may refer to a target cell to be soldered for manufacturing the solar cell module, and may refer to a cell that is positioned under the infrared radiation device in the Z direction to face the infrared radiation device. In addition, in this specification, ^{┌}soldering standby cell_{┘} may refer to a solar cell for which the soldering is not performed yet and refer to a cell positioned at a back end in the X direction compared to the working target cell, and ^{┌}soldering completed cell_{┘} may refer to a solar cell for which the soldering has been completed and refer to a cell positioned at a front end in the X direction compared to the working target cell.

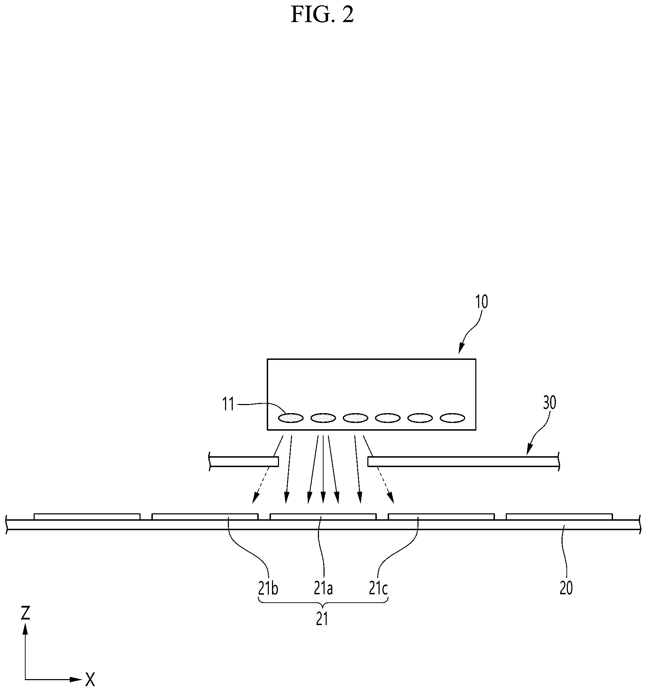

FIG. 1 is a perspective view illustrating an exemplary form of a tabbing apparatus for manufacturing solar cell modules, and FIG. 2 is a schematic view for explaining the operation of the tabbing apparatus for manufacturing solar cell modules according to an embodiment. Referring to FIGS. 1 and 2, a tabbing apparatus for manufacturing solar cell modules may include a soldering head 10 and a conveyor 20.

In order to manufacture the solar cell module, solar cells 21 applied to the tabbing apparatus for manufacturing solar cell modules according to the present disclosure may be individually transported on the conveyor 20 by a unit of cell. The conveyor 20 is an apparatus for transporting the solar cells 21 and each of the solar cells 21 may be individually disposed on the conveyor 20, and each solar cell 21 may be transported toward the soldering head 10 as the conveyor 20 moves.

A solder is coated on a surface of each module solar cell 21 for electrically connecting to wiring materials etc. The solder is soldered by a heat source.

The soldering head 10 may be installed over the solar cell 21 that is to be soldered and may perform the function of soldering the solder coated on the solar cell 21 that is transported. An infrared radiation device 11 may be disposed in the soldering head 10 such that infrared rays are directly radiated to the cell to solder wiring material on the surface of the solar cell 21 disposed on the conveyor 20. The infrared radiation device 11 is not particularly limited as long as the working target cell is heated to an appropriate temperature, and may be, for example, an infrared lamp or a halogen lamp.

A plurality of the infrared radiation devices 11 may be provided in the soldering head 10, but the present disclosure is not limited thereto. In addition, many other components for the soldering may be installed in the soldering head 10, for example, an air nozzle may be installed inside to directly provide air therein for temperature control, or a ventilation device may be installed, but this is not limited thereto.

An over-soldering prevention member 30 may be disposed between the infrared radiation device 11 and the conveyor 20. The over-soldering prevention member 30 may include a light blocking portion 31 and a light transmitting portion 32 disposed in the light blocking portion 31.

The light blocking portion 31 may block at least a portion of the infrared rays emitted from the infrared radiation device 11, for example, at least a portion of the infrared rays that are emitted from the infrared radiation device 11 and radiated toward the conveyor 20. The light transmitting portion 32 may be positioned inside the light blocking portion 31 that is defined in the X-axis direction and the Y-axis direction, and may refer to, for example, an area in which the light blocking portion 31 is not disposed.

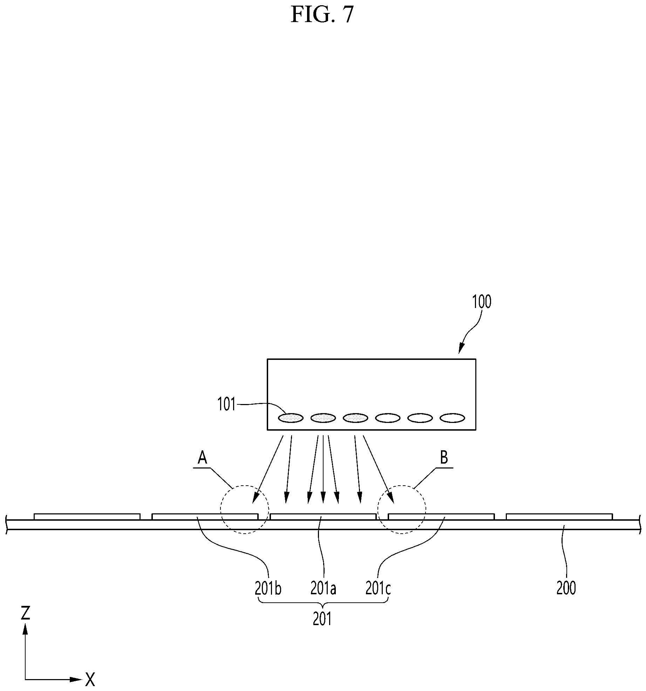

FIG. 7 is a schematic view for explaining operation of the conventional tabbing apparatus for manufacturing solar cell modules. Referring to FIG. 7, the conventional tabbing apparatus for manufacturing solar cell modules solders the wiring material disposed on the surface of the working target cell 201a by using infrared rays emitted from the infrared radiation device 101 in the soldering head 100. A soldering completed cell 201c for which the previous work is completed may be positioned at a front end of the working target cell 201a that is disposed on the conveyor 200 in the longitudinal direction, and a soldering standby cell 201b which is not soldered may be positioned at a back end of the working target cell 201a in the longitudinal direction.

At this time, in the process of radiating infrared rays to the working target cell 201a, the infrared rays may also be radiated to the soldering completed cell 201c for which the work has already been completed and/or the soldering standby cell 201b for which the work has not yet been performed. As illustrated in FIG. 7, when the infrared rays are radiated to the soldering completed cell 201c, the solar cell, which has been heated in the soldering process, cannot be cooled and an additional heating area B may occur. As a result, a surface temperature of the soldering completed cell 201c may become excessively high, and the over-soldering may occur. In addition, when the infrared rays are radiated to the soldering standby cell 201b, a surface temperature of the cell may increase before the work and a pre-heating area A may occur. In this case, the solar cell whose surface has been heated is transported to the position of the working target cell 201a and the infrared rays are radiated to the solar cell whose surface is heated, so that the working target cell 201a is heated to a temperature higher than the desired soldering temperature, thereby resulting in the over-soldering.

The tabbing apparatus for manufacturing solar cell modules according to the present disclosure may include the over-soldering prevention member 30 to control the area to which the infrared rays emitted from the infrared radiation device 11 are radiated, thereby locally adjusting the heating area. In addition, the surplus infrared rays emitted from the infrared radiation device 11 may be prevented from being radiated to the soldering standby cell 21b and/or the soldering completed cell 21c, thereby preventing the over-soldering.

In an example embodiment of the present disclosure, the light blocking portion 31 of the over-soldering prevention member 30 in the tabbing apparatus for manufacturing solar cell modules according to the present disclosure may be disposed to block the infrared rays from being emitted to the soldering completed cell 21c from the infrared radiation device 11. The fact that the light blocking portion 31 is disposed to block the infrared rays from being emitted to the soldering completed cell 21c may indicate that the light blocking portion 31 is disposed at a side in a forward direction of the conveyor 20 with respect to the infrared radiation device 11 and is positioned in the X direction from the infrared radiation device 11. When the light blocking portion 31 is disposed as described above, the infrared rays emitted outwards from the soldering head 10 may be prevented from being radiated to the soldering completed cell 21c, and the over-soldering of the soldering completed cell 21c may be prevented.

In another example embodiment of the present disclosure, the light blocking portion 31 of the over-soldering prevention member 30 in the tabbing apparatus for manufacturing solar cell modules according to the present disclosure may be disposed to block the infrared rays from being emitted to the soldering standby cell 21b from the infrared radiation device 11. The fact that the light blocking portion 31 is disposed to block the infrared rays from being emitted to the soldering standby cell 21b may indicate that the light blocking portion 31 is disposed at a side opposite to the moving direction of the conveyor 20 with respect to the infrared radiation device 11 and is positioned opposite to the X direction from the infrared radiation device 11. When the light blocking portion 31 is disposed as described above, the infrared rays emitted outwards from the soldering head 10 may be prevented from being radiated to the soldering standby cell 21b, and the over-soldering may be prevented when the soldering standby cell 21b is transported to the position of the working target cell 21a.

In an example embodiment, the light blocking portion 31 of the over-soldering prevention member 30 in the tabbing apparatus for manufacturing solar cell modules according to the present disclosure may be disposed to block the infrared rays emitting to areas other than the working target cell 21a among the infrared rays emitted to the outside of the soldering head 10 from the infrared radiation device 11. The fact that the light blocking portion 31 is disposed to block the infrared rays emitting to areas other than the working target cell 21a may indicate that the light blocking portion 31 is positioned to make the infrared rays emitted from the infrared radiation device 11 not reach the soldering standby cell 21b and the soldering completed cell 21c. Accordingly, the over-soldering may be prevented at the soldering standby cell 21b and the soldering completed cell 21c.

In an embodiment of the present disclosure, the width of the infrared ray, which is radiated from the infrared radiation device 11 to the surface of the solar cell 21 positioned on the conveyor 20 in the tabbing apparatus for manufacturing solar cell modules according to the present disclosure, may be greater than the width of the wiring material attached to the solar cell 21. The width of the wiring material may be an arithmetic average of the widths of the wiring materials from the working target cell 21a to the third soldering standby cell, excluding the working target cell and the widths of the wiring materials from the working target cell 21a to the third soldering completed cell, excluding the working target cell. The width of the infrared ray and the width of the wiring material may be values measured in a direction parallel to the Y direction. As in this embodiment, the width of the infrared ray, which is radiated from the infrared radiation device 11 to the surface of the solar cell 21 positioned on the conveyor 20, may be set greater than the width of the wiring material attached to the solar cell 21, to thereby prevent non-soldering by sufficiently heating the working target cell as well as the over-soldering.

In another embodiment of the present disclosure, a length of the infrared ray, which is radiated from the infrared radiation device 11 to the surface of the solar cell 21 positioned on the conveyor 20 in the tabbing apparatus for manufacturing solar cell modules according to the present disclosure, may be greater than a length of the wiring material attached to the solar cell 21. The length of the wiring material may be an arithmetic average of the lengths of the wiring materials from the working target cell 21a to the third soldering standby cell 21b, excluding the working target cell 21a and the lengths of the wiring materials from the working target cell 21a to the third soldering completed cell 21c, excluding the working target cell 21a. The length of the infrared ray and the length of the wiring material may be values measured in a direction parallel to the X direction. As in this embodiment, the length of the infrared ray, which is radiated from the infrared radiation device 11 to the surface of the solar cell 21 positioned on the conveyor 20, may be set greater than the length of the wiring material attached to the solar cell 21, to thereby prevent non-soldering by sufficiently heating the working target cell 21a as well as the over-soldering.

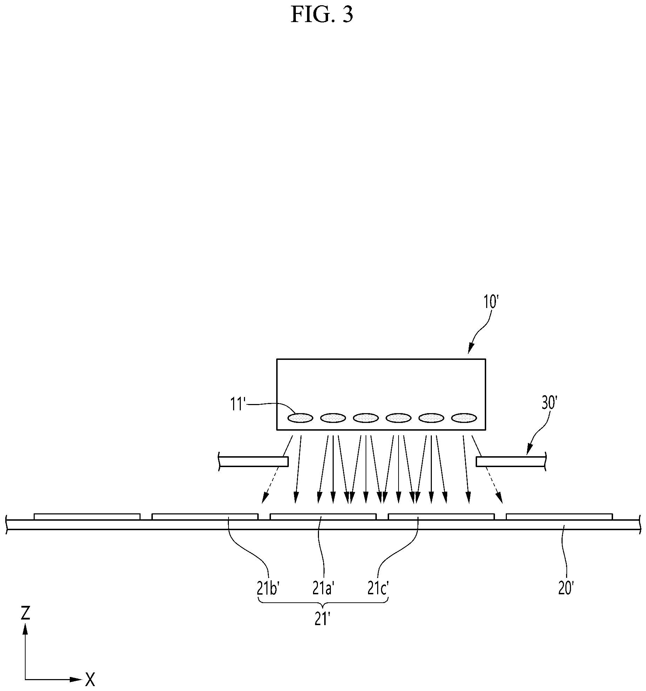

FIG. 3 is a schematic view for explaining operation of a tabbing apparatus for manufacturing solar cell modules according to another modified embodiment of the tabbing apparatus for manufacturing solar cell modules according to the present disclosure. Referring to FIG. 3, a soldering head 10' of the tabbing apparatus for manufacturing solar cell modules according to another modified embodiment of the tabbing apparatus for manufacturing solar cell modules according to the present disclosure may include an infrared radiation device 11' and the infrared radiation device 11' may be disposed to radiate infrared rays to a plurality of working target cells 21a' disposed on the conveyor 20'. At this time, as described above, an over-soldering prevention member 30' may be disposed to block the infrared rays emitted from the infrared radiation device 11' from reaching a soldering completed cell 21c' and/or a soldering standby cell 21b'.

In an embodiment of the present disclosure, the over-soldering prevention member 30 in the tabbing apparatus for manufacturing solar cell modules according to the present disclosure may include an opening portion 33. The opening portion 33 may have a structure connected to the light transmitting portion 32, and may have, for example, a structure formed by extending the light transmitting portion 32 in the direction of the light blocking portion 31. An end of the opening portion 33 in the X direction, which is formed in the direction directed to the light blocking portion 31 from the light transmitting portion 32, may be positioned at the outside of the X direction more than an end of the light transmitting portion 32 in the X direction.

In an embodiment of the present disclosure, the opening portion 33 provided in the over-soldering prevention member 30 of the tabbing apparatus for manufacturing solar cell modules according to the present disclosure may be formed and disposed in a direction opposite to the moving direction of the conveyor 20. The fact that the opening portion 33 is formed in a direction opposite to the moving direction of the conveyor 20 may indicate that any one end of the opening portion 33 protrudes in a direction opposite to the moving direction of the conveyor 20 and that an end of the opening portion 33 is disposed further away from the working target cell 21a than the end of the light transmitting portion 32.

The opening portion 33 may perform the function of preventing non-soldering in the tabbing apparatus for manufacturing solar cell modules according to the present disclosure. When the soldering standby cell 21b is transported to the position of the working target cell 21a, the working target cell 21a is heated by infrared rays emitted from the infrared radiation device 11. At this time, since the central portion of the working target cell 21a is heated by the infrared rays radiated from the infrared radiation device 11 and is positioned between the peripheral portions of the cell that are heated by the infrared rays radiated to the peripheral portion at the same time, it may be less affected by external temperature. On the other hand, the central portion described above is disposed on one side of the peripheral portion of the working target cell 21a in the Y direction, however, the other side of the peripheral portion in the Y direction is exposed to the outside and cooled down, which may cause the non-soldering. When the soldering standby cell 21b is transported to the position of the working target cell 21a, the peripheral portion of the cell may be pre-heated through the opening portion 33, which allows the peripheral portion of the working target cell 21a to maintain an appropriate temperature to prevent the non-soldering of the working target cell 212a.

In another embodiment of the present disclosure, the opening portion 33 provided in the over-soldering prevention member 30 of the tabbing apparatus for manufacturing solar cell modules according to the present disclosure may be formed and disposed in the moving direction of the conveyor 20. The fact that the opening portion 33 is formed in the moving direction of the conveyor 20 may indicate that any one end of the opening portion 33 protrudes in the moving direction of the conveyor 20 and that an end of the opening portion 33 is disposed further away from the working target cell 21a than the end of the light transmitting portion 32.

The opening portion 33 provided in the over-soldering prevention member 30 may be formed and disposed in, for example, both the moving direction of the conveyor 20 and the opposite direction of the moving direction of the conveyor 20, but this is not limited thereto.

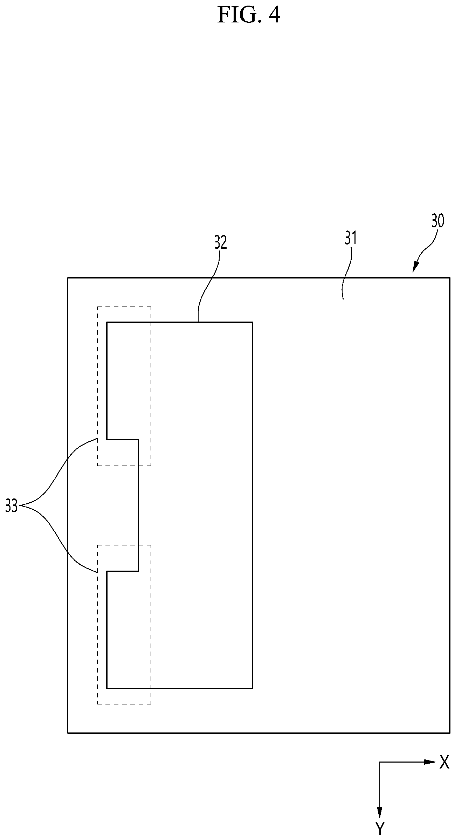

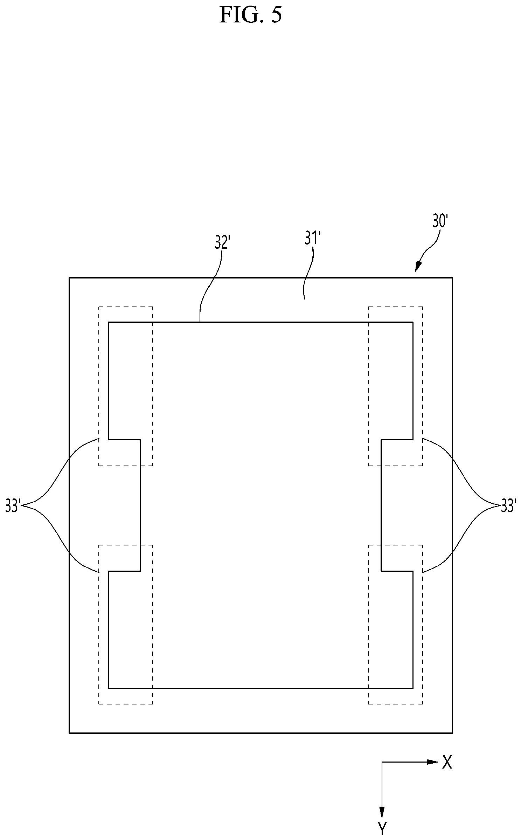

In an embodiment, the opening portion 33 of the tabbing apparatus for manufacturing solar cell modules according to the present disclosure may be disposed on opposite sides of the light blocking portion 31 in the width direction. The opening portion 33 provided in the over-soldering prevention member 30 according to the present disclosure is disposed to prevent the peripheral portion of the working target cell 21a from cooling early in the manufacturing process for the solar cell module, and may be positioned on opposite sides in the Y direction as illustrated in FIGS. 4 and 5. The opening portion 33 may be disposed to face each other in the Y direction. The opening portion 33 may have a square shape as illustrated in FIGS. 4 and 5, but this is not limited thereto, and may have a shape of a polygon or curve other than the square depending on various factors such as the heating speed of the working target cell 21a, the moving speed of the conveyor 20, and the intensity of infrared rays.

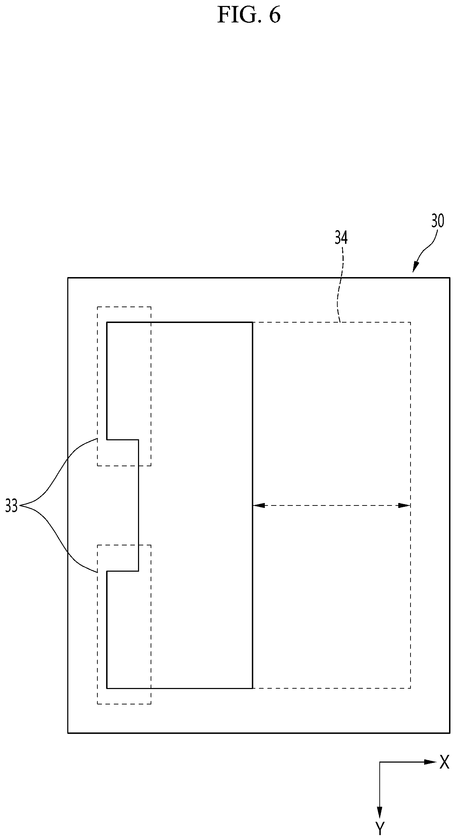

In an embodiment of the present disclosure, the over-soldering prevention member 30 may further include an adjuster 34 capable of adjusting the length of the light transmitting portion 31. FIG. 6 is a plan view schematically illustrating the over-soldering prevention member 30 in the tabbing apparatus for manufacturing solar cell modules according to the present embodiment. Referring to FIG. 6, the adjuster 34 may have a function of adjusting the position of one end of the light transmitting portion 32 in the X direction and the end position of the light transmitting portion 32 is adjusted in the X direction by the adjuster 34, so that the radiation range of the infrared rays radiated from the infrared radiation device 11 to the conveyor 20 may be adjusted in the X direction.

On the other hand, as a non-limiting embodiment, in the tabbing apparatus for manufacturing solar cell modules according to an embodiment of the present disclosure, an air nozzle may be installed to cool the working target cell by spraying air. At this time, the air nozzle is installed on an outer side surface of the soldering head 10 and is connected to a pump by a plurality of joints, so that the operator may easily adjust the spraying position by bending or straightening the joints.

Although the embodiments of the present disclosure have been described in detail above, the present disclosure is not limited by the above-described embodiments and the attached drawings, but is intended to be limited by the accompanying claims. Accordingly, various forms of substitution, modification, and change may be made by those skilled in the art without departing from the technical spirit of the present disclosure as described in the claims, which also fall within the scope of the present disclosure.

### INDUSTRIAL APPLICABILITY

One of the many effects of the present disclosure is to prevent the over-soldering in the manufacturing process for the solar cell module.

One of the many effects of the present disclosure is to provide a tabbing apparatus for manufacturing solar cell modules capable of heating a local area.

One of the many effects of the present disclosure is to provide a tabbing apparatus for manufacturing solar cell modules in which the soldering area is easily adjusted.

## Claims

1. A tabbing apparatus for manufacturing solar cell modules, the tabbing apparatus comprising: a conveyor for transporting sequentially solar cells including a soldering completed cell, a working target cell, and a soldering standby cell; a soldering head in which an infrared radiation device for directly radiating infrared rays to the cell is disposed such that a wiring material on a surface of the solar cell, which is disposed on the conveyor, is soldered; and an over-soldering prevention member disposed between the conveyor and the soldering head and including a light blocking portion and a light transmitting portion inside the light blocking portion, wherein the over-soldering prevention member includes an opening portion having a structure in which the light transmitting portion extends towards the light blocking portion.

2. The tabbing apparatus for manufacturing solar cell modules of claim 1, wherein the light blocking portion of the over-soldering prevention member is disposed to block the infrared rays emitted to the soldering completed cell that is positioned below the infrared radiation device.

3. The tabbing apparatus for manufacturing solar cell modules of claim 1, wherein the light blocking portion of the over-soldering prevention member is disposed to block the infrared rays emitted to the soldering standby cell that is positioned below the infrared radiation device.

4. The tabbing apparatus for manufacturing solar cell modules of claim 1, wherein the light blocking portion of the over-soldering prevention member is disposed to block the infrared rays emitted to areas other than the working target cell that is positioned below the infrared radiation device.

5. The tabbing apparatus for manufacturing solar cell modules of claim 1,wherein a width of the infrared ray that is radiated from the infrared radiation device to the surface of the solar cell which is positioned on the conveyor is greater than a width of the wiring material attached to the solar cell.

6. The tabbing apparatus for manufacturing solar cell modules of claim 1, wherein a length of the infrared ray that is radiated from the infrared radiation device to the surface of the solar cell which is positioned on the conveyor is greater than a length of the wiring material attached to the solar cell.

7. The tabbing apparatus for manufacturing solar cell modules of claim 1, wherein the opening portion is disposed at a side opposite to a moving direction of the conveyor.

8. The tabbing apparatus for manufacturing solar cell modules of claim 1, wherein the opening portion is disposed on opposite sides of the light blocking portion in a width direction.

9. The tabbing apparatus for manufacturing solar cell modules of claim 1, wherein the over-soldering prevention member further includes an adjuster capable of adjusting a length of the light transmitting portion.

10. The tabbing apparatus for manufacturing solar cell modules of claim 1, wherein the infrared radiation device is an infrared lamp or a halogen lamp.
